# FASCICULE DE BREVET EUROPEEN

(11) **EP 0 403 413 B1**
(45) Date de publication et mention de la délivrance du brevet: **17.04.1996**
(21) Numéro de dépôt: 90470035.8
(22) Date de dépôt: 07.06.1990
(51) Int. Cl.: H05B 7/144

(54) **Procédé et dispositif pour mesurer l'instabilité d'un arc dans un four électrique de traitement de métal liquide**
Verfahren und Anordnung zur Messung der Instabilität eines Bogens in einem elektrischen Ofen zur Behandlung von flüssigen Metallen
Procedure and device for measuring the instability of an arc in an electric furnace for the treatment of liquid metals

(30) Priorité: 15.06.1989 FR 8907951
(43) Date de publication de la demande: 19.12.1990
(73) Titulaire: SPIE TRINDEL, S.A., F-95863 Cergy Pontoise (FR)
(72) Inventeur: Bourge, Michel, F-54340 Arnaville (FR); Engler, Gilbert, F-57140 Woippy (FR); Maurer, Ghislain, F-57160 Chatel-St-Germain (FR)
(74) Mandataire: Ventavoli, Roger

(56) Documents cités:
- EP-A- 0 317 948
- DE-A- 3 149 175
- PATENT ABSTRACTS OF JAPAN vol. 10, no. 13 (M-782)(3358) 11 janvier 1989,& JP-A-63 220978(SUMITOMO METAL IND,LTD) 14 septembre 1988

## Description

La présente invention a pour objet un procédé et un dispositif pour mesurer l'instabilité d'un arc dans un four électrique de traitement de métal liquide, notamment dans une aciérie.

On sait que les caractéristiques de l'arc d'un four électrique sont susceptibles de varier durant une élaboration de métal liquide.

Par ailleurs, le laitier qui surnage au-dessus du bain de métal liquide subit, durant l'affinage de l'acier, un moussage provoqué par les réactions chimiques dans le métal liquide et dans le laitier, consécutives à l'injection d'oxygène et de charbon par des lances respectivement dans le métal liquide et dans le laitier. En effet, l'injection d'oxygène provoque la formation d'oxyde de fer qui passe dans le laitier, où l'injection de charbon provoque la formation d'oxyde de carbone qui fait mousser le laitier. L'arc est donc plus ou moins immergé dans la couche de laitier pendant le processus d'affinage.

L'immersion de l'arc au sein d'un laitier est en soi un avantage recherché par les aciéristes, car de cette façon on protège les parois du four, qui, sinon, seraient directement exposées au rayonnement des arcs. Le Document EP-A-0317948 décrit d'ailleurs à ce sujet un moyen de réglage du degré d'exposition de l'arc basé sur une grandeur représentative du courant électrique qui passe dans l'arc, à savoir l'intensité de ce courant.

Or, on a constaté qu'il existe une corrélation entre la distorsion de l'intensité du courant dans l'arc électrique et le moussage du laitier. En effet, le moussage influe sur les caractéristiques de l'arc électrique, à savoir sa tension et l'intensité du courant.

L'invention a pour objet de permettre la conduite du processus dans le four à partir de l'évolution du moussage du laitier.

Le procédé conforme à l'invention est ainsi caractérisé en ce que :
- on capte un signal représentant la dérivée de l'intensité du courant dans l'arc,
- on amplifie le signal capté,
- on achemine le signal amplifié simultanément dans deux filtres passe-bande respectivement à bande large haute fréquence et à bande étroite centrée sur une basse fréquence fondamentale,
- on transmet les signaux issus des filtres à des extracteurs de valeur efficace,
- on élabore au moyen d'un module diviseur un signal proportionnel au rapport de la valeur efficace du signal issu du filtre à bande large et de la valeur efficace du signal issu du filtre à bande étroite,
- et on affiche le signal proportionnel obtenu sur une échelle où il est exprimé en pourcentage, ce pourcentage étant indicatif de la tenue de l'arc.

Dans le cas où la couche de laitier subit effectivement un moussage durant le processus, l'arc étant ainsi immergé dans la mousse, on utilise le signal proportionnel obtenu comme indicateur du degré d'immersion de l'arc dans le laitier moussant, la valeur dudit signal tendant vers un minimum lorsque le moussage du laitier provoque une immersion maximale de l'arc.

On mesure ainsi la distorsion harmonique du courant, qui constitue une image de la stabilité de l'arc, améliorée lorsque celui-ci est immergé dans la mousse. Les opérateurs conduisant la marche du four disposent alors d'un indicateur leur permettant des réglages en temps réel, d'homogénéiser les consignes entre les équipes, et de fournir un indicateur de SPC (contrôle statistique de procédé).

L'invention a également pour objet un dispositif pour la mise en oeuvre de ce procédé qui comprend :
- un capteur d'un signal représentant la dérivée de l'intensité du courant passant dans l'arc,
- un amplificateur dudit signal,
- deux filtres passe-bande reliés à l'amplificateur, dont l'un est à bande large haute fréquence et l'autre à bande étroite centrée sur une basse fréquence fondamentale,
- deux extracteurs de valeur efficace reliés respectivement aux filtres précités,
- un module diviseur relié aux extracteurs et capable d'élaborer un signal proportionnel au rapport de la valeur efficace du signal issu du filtre à bande large et de la valeur efficace du signal issu du filtre à bande étroite,
- un organe d'affichage en pourcentage du signal proportionnel délivré par le module diviseur,
- et une liaison éventuelle avec un calculateur.

D'autres particularités et avantages de l'invention apparaîtront au cours de la description qui va suivre, faite en référence au dessin annexé qui en illustre une forme de réalisation à titre d'exemple non limitatif.

La figure 1 est une vue en coupe schématique d'un four électrique d'élaboration de métal liquide.

La figure 2 est un schéma synoptique du dispositif de mise en oeuvre du procédé de mesure de l'instabilité de l'arc du four électrique de la Fig. 1.

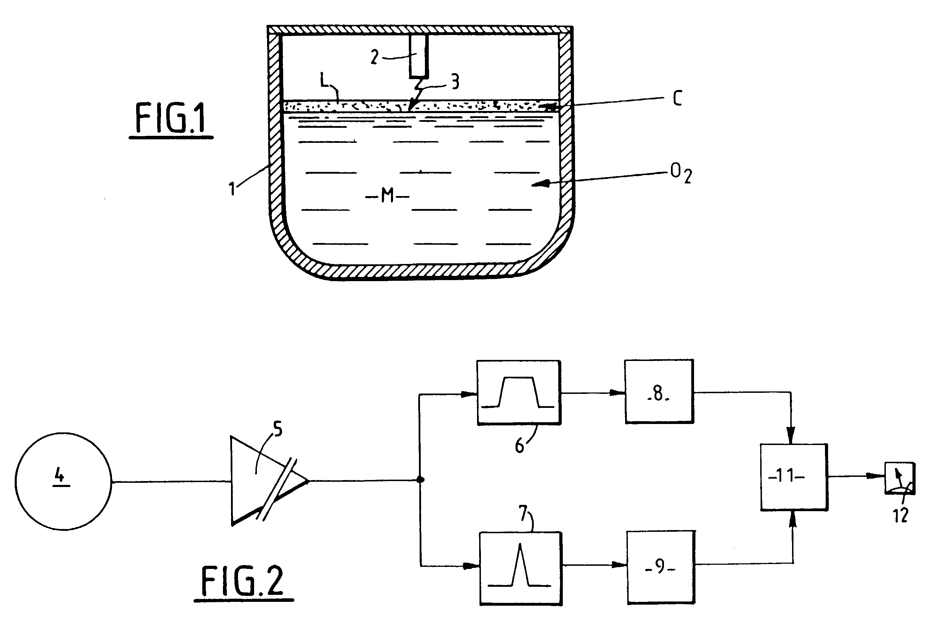

Le four électrique 1 de la Fig. 1 comporte une électrode 2 et contient un bain de métal liquide M. Au dessus du métal liquide M se trouve durant le processus une couche L de laitier, traversée à un degré variable par l'arc électrique 3.

Des lances non représentées, symbolisées par les flèches traversant la paroi du four 1, permettent l'injection respectivement d'oxygène dans le métal liquide M et de charbon dans le laitier L. Ces injections provoquent des réactions chimiques dans le bain et dans le laitier, qui à leur tour provoquent un moussage de ce dernier, à l'intérieur duquel est donc immergé plus ou moins l'arc 3, ce qui influe sur la tension et le courant dans l'arc.

Pour suivre l'évolution du mous sage du laitier L et ainsi permettre des interventions en cours de processus, l'invention prévoit un système électrique dont le circuit est représenté à la Fig.2.

Ce dispositif de mesure comprend ainsi :
- un capteur 4 d'un signal représentant la dérivée di/dt de l'intensité du courant passant par l'arc, mesurée sur l'un des conducteurs du circuit secondaire du four,
- un amplificateur 5 du signal fourni par le capteur 4,
- deux filtres passe-bande reliés à l'amplificateur 5, dont l'un 6 est à bande large haute fréquence et l'autre 7 à bande étroite centrée sur une basse fréquence fondamentale,
- deux extracteurs de valeur efficace 8, 9 reliés respectivement aux filtres précités 6 et 7,
- un module diviseur 11 relié aux extracteurs 6, 7 et capable d'élaborer un signal énergétique proportionnel au rapport de la valeur efficace du signal issu du filtre à bande large 6 et de la valeur efficace du signal issu du filtre à bande étroite 7;
- et enfin un organe 12 d'affichage en pourcentage du signal énergétique proportionnel délivré par le module diviseur 11.

Le capteur 4 est du type inductif, par exemple tore de Robowski, c'est-à-dire un ampèremètre électromagnétique pouvant mesurer la dérivée du courant, et ses harmoniques. L'utilisation d'un capteur de ce type présente notamment l'avantage d'accroître la précision de la mesure des fluctuations du courant car sa bande passante très large évite un écrêtage des composantes hautes fréquences. L'amplificateur 5 est un amplificateur d'isolement, par exemple à séparation galvanique. Les filtres 6 et 7 dissocient le signal d'origine en deux branches dans chaque filtre. Le filtre 6 peut ainsi être un passe-bande de 500 à 1000Hz à pente voisine de 50dB/octave, tandis que le filtre 7 est à bande étroite centrée sur une basse fréquence par exemple 50Hz dans le cas d'une alimentation du four en courant alternatif à fréquence industrielle. Les deux filtres 6 et 7 réalisent ainsi la séparation entre la composante fréquentielle fondamentale à 50Hz et les composantes fréquentielles situées dans la bande 500 à 1000Hz, cette bande de fréquences s'étant révélée particulièrement intéressante, quant à la précision de la mesure et du traitement du signal, pour la mise en oeuvre du procédé.

La valeur énergétique des deux signaux issus des deux filtres 6, 7 est obtenue par les deux extracteurs 8, 9 de valeur efficace, dont les caractéristiques sont identiques ("root mean square"). Les extracteurs 8 et 9 reçoivent à l'entrée des signaux alternatifs et délivrent des signaux continus, et doivent avoir rigoureusement les mêmes caractéristiques d'intégration.

Le diviseur 11 calcule le rapport des valeurs énergétiques des signaux fournis par les extracteurs 8 et 9, le résultat de ce calcul étant affiché sur l'organe 12.

Le signal fourni par le diviseur 11 peut être considéré comme un indicateur de moussage du laitier L, du fait que sa valeur tend vers un minimum lorsque le moussage du laitier provoque une immersion maximale de l'arc 3. Ainsi la valeur du quotient délivré par le diviseur 11 est minimum lorsque le moussage est maximum (l'arc 3 étant complètement enveloppé de mousse) et inversement.

Ceci peut se comprendre par le fait que le développement du mous sage provoque une diminution des harmoniques du courant, qui provoque à son tour une diminution du rapport du signal énergétique délivré par l'extracteur 8 au signal énergétique délivré par l'extracteur 9.

Bien entendu, la zone 500-1000Hz donnée ci-dessus n'est fournie qu'à titre d'exemple, car pour un bain de métal liquide M elle est la plus riche en informations. En dehors de cette bande, plus on s'approche de la fréquence fondamentale, plus doit être utilisé un filtre à pente raide. C'est pourquoi on choisit une fenêtre de fréquence appropriée. Le plafond de 1000Hz s'est révélé dans l'exemple donné approprié, car au-delà d'une certaine fréquence (qui peut être différente de 1000Hz, par exemple 2000Hz) les informations supplémentaires obtenues ne sont plus utiles.

Les résultats fournis par l'indicateur 12 peuvent être utilisés de la manière suivante :

1. Pour le réglage en temps réel du four 1 bar l'opérateur de contrôle. En effet si le signal de l'organe 12 est maximum, cela signifie que l'arc 3 est très peu immergé dans la mousse et que s'impose un réglage de la marche du four, par exemple un positionnement différent des lances d'injection d'oxygene et de charbon, ou un réglage des débits d'injection.

2. Optimisation de la marche du four. Il est possible de fournir à l'indicateur 12 des valeurs de consigne auxquelles seront liés des ordres d'intervention déterminés, pour le réglage de certains paramètres en fonction des valeurs enregistrées.

En l'absence de moussage du laitier L, le procédé selon l'invention permet de suivre la tenue de l'arc 3, qui est influencée par d'autres paramètres que le moussage. Ainsi par exemple pendant les phases de fusion des paniers de ferrailles à partir d'un pourcentage donné, par exemple 50%, de l'indicateur 12, on saura que le four est en fin de fusion, et qu'il faut alors le recharger pour conserver un rendement maximum. Le procédé peut ainsi être mis à profit pour maintenir les caractéristiques de l'arc à des valeurs constantes.

On notera que le filtre 6, dans l'exemple indicatif donné ci-dessus, peut être en fait constitué par une succession de deux filtres à deux cellules, le premier étant passe bas 1000Hz et le second étant passe haut 500Hz. Le gain est réglé à 0 ou 20dB, seule la première cellule étant réglée à 20dB pour la comptabilité des signaux sur le diviseur 11.

Toutefois un seul filtre 6 peut suffire, avec une première cellule réglée à 1000Hz et une deuxième cellule réglée à 500Hz, et le gain de l'une des deux à 20dB.

Le procédé et le dispositif décrit ci-dessus à titre d'exemple dans le cas d'un four à courant alternatif, peuvent également s'appliquer aux fours à courant continu, la basse fréquence fondamentale considérée étant alors pratiquement nulle, et le filtre à bande étroite étant alors un filtre passe-bas 1 Hz par exemple, la bande haute fréquence pouvant éventuellement être élargie, par exemple à 50-1000 Hz.

## Revendications

1. Procédé pour mesurer l'instabilité d'un arc (3) dans un four électrique (1) de traitement d'un métal liquide, selon lequel on prend en compte une grandeur représentative du courant électrique qui passe dans l'arc, caractérisé en ce que :
- on capte un signal représentant la dérivée (di/dt) de l'intensité du courant dans l'arc,
- on amplifie le signal capté,
- on achemine le signal amplifié simultanément dans deux filtres passe-bande (6,7) respectivement à bande large haute fréquence (6) et à bande étroite centrée sur une basse fréquence fondamentale (7),
- on transmet les signaux issus des filtres (6,7) à des extracteurs (8,9) de valeur efficace,
- on élaborer au moyen d'un module diviseur (11) un signal proportionnel au rapport de la valeur efficace du signal issu du filtre à bande large (6) et de la valeur efficace du signal issu du filtre à bande étroite (7),
- et on affiche le signal proportionnel obtenu sur une échelle (12) où il est exprimé en pourcentage, ce pourcentage étant indicatif de la tenue de l'arc.

2. Procédé selon la revendication 1, mise en oeuvre dans un four où le bain de métal liquide (M) est recouvert d'une couche de laitier moussant (L) partiellement au moins traversée par l'arc (3), caractérisé en ce qu'on utilise ledit signal proportionnel obtenu comme indicateur du degré d'immersion de l'arc (3) dans le laitier moussant (L), la valeur dudit signal tendant vers un minimum lorsque le moussage du laitier provoque une immersion maximale de l'arc.

3. Dispositif pour la mise en oeuvre du procédé selon la revendication 1 ou 2, caractérisé en ce qu'il comprend :
- un capteur (4) d'un signal représentant la dérivée (di/dt) de l'intensité du courant passant dans l'arc (3),
- un amplificateur (5) dudit signal,
- deux filtres passe-bande (6,7) reliés à l'amplificateur (5), dont l'un (6) est à bande large haute fréquence et l'autre (7) à bande étroite centrée sur une basse fréquence fondamentale,
- deux extracteurs de valeur efficace (8,9) reliés respectivement aux filtres précités (6,7),
- un module diviseur (11) relié aux extracteurs (8,9) et capable d'élaborer un signal proportionnel au rapport de la valeur efficace du signal issu du filtre à bande large (6) et de la valeur efficace du signal issu du filtre à bande étroite (7),
- un organe d'affichage (12) en pourcentage du signal proportionnel délivré par le module diviseur (11),
- et une liaison éventuelle avec un calculateur.

4. Dispositif selon la revendication 3, caractérisé en ce que le capteur (4) est du type inductif, par exemple un tore de Robowski.

5. Dispositif selon l'une des revendications 3 ou 4, caractérisé en ce que l'amplificateur (5) est d'isolement, par exemple à séparation galvanique.

6. Dispositif selon l'une des revendications 3 à 5, caractérisé en ce que le filtre à bande large (6) peut isoler une bande comprise entre 500 et 1 000 Hz, et le filtre à bande étroite (7) peut isoler une bande centrée sur une fréquence fondamentale de 50 Hz.

7. Dispositif selon la revendication 6, caractérisé en ce que les extracteurs de valeur efficace (8,9) ont des caractéristiques identiques.

## Patentansprüche

1. Verfahren zur Messung der Instabilität eines Lichtbogens (3) in einem elektrischen Ofen (1) zur Verarbeitung von flüssigem Metall, wobei eine Größe berücksichtigt wird, die repräsentativ für den im Lichtbogen fließenden elektrischen Strom ist, dadurch gekennzeichnet, daß
- ein Signal aufgenommen wird, das die Ableitung (di/dt) der Stromintensität im Lichtbogen darstellt,
- das aufgenommene Signal verstärkt wird,
- das verstärkte Signal gleichzeitig zwei Bandpaßfilter (6, 7) durchläuft, und zwar eines mit einem breiten hochfrequenten Band (6) und eines mit einem schmalen, zu einer niedrigen Grundfrequenz zentrierten Band (7),
- die von den Filtern (6, 7) abgegebenen Signale Effektivwert-Gleichrichtern (8, 9) zugeführt werden,
- mittels einer Teilerstufe (11) ein Signal erstellt wird, das proportional ist zum Verhältnis des Effektivwertes des vom Filter mit dem breiten Band (6) stammenden Signals zum Effektivwert des vom Filter mit dem schmalen Band (7) stammenden Signals, und
- das derart erhaltene proportionale Signal auf einer Skala (12) dargestellt wird und zwar als Prozentaussage, wobei diese Prozentaussage eine Anzeige des Lichtbogenverhaltens ist.

2. Verfahren nach Anspruch 1, verwendet in einem Ofen, in dem das Bad aus flüssigem Metall (M) von einer aufgeschäumten Schlackenschicht (L) bedeckt ist und zumindest teilweise vom Lichtbogen (3) durchsetzt wird, dadurch gekennzeichnet, daß das erhaltene proportionale Signal als Anzeige für den Grad des Eintauchens des Lichtbogens (3) in die aufgeschäumte Schlacke (L) verwendet wird, wobei der Wert des Signals sich in Richtung zu einem Mininalwert verändert, wenn die Aufschäumung der Schlacke ein maximales Eintauchen des Lichtbogens bewirkt.

3. Vorrichtung zur Durchführung des Verfahrens nach Ansprüchen 1 oder 2, dadurch gekennzeichnet, daß sie aufweist;
- einen Fühler 4 für ein Signal, welches die Ableitung (di/dt) der im Lichtbogen (3) fließenden Stromintensität darstellt,
- einen Verstärker (5) für dieses Signal,
- zwei Bandpaßfilter (6, 7), die mit dem Verstärker (5) verbunden sind, wobei eines (6) ein hochfrequentes breites Band aufweist und das andere (7) ein schmales, auf eine niedrige Grundfrequenz zentriertes Band aufweist,
- zwei Effektivwert-Gleichrichter (8, 9), die mit den entsprechenden Filtern (6, 7) verbunden sind,
- eine Teilerstufe (11), welche mit den Gleichrichtern (8,9) verbunden ist und die in der Lage ist, ein Signal zu erstellen, das proportional ist zum Verhältnis des Effektivwertes des vom Filter mit dem breiten Brand (6) stammenden Signals zum Effektivwert des vom Filter mit dem schmalen Band (7) stammenden Signals,
- eine Anzeigenanordnung (12) für eine Prozentaussage des proportionalen, von der Teilerstufe (11) stammenden Signals, und
- gegebenenfalls eine Verbindung zu einem Rechner.

4. Vorrichtung nach Anspruch 3, dadurch gekennzeichnet, daß der Fühler (4) ein induktiver Fühler ist, zum Beispiel ein Robowski-Torus.

5. Vorrichtung nach einem Ansprüche 3 oder 4, dadurch gekennzeichnet, daß der Verstärker (5) ein Isolationsverstärker ist, zum Beispiel mit galvanischer Trennung.

6. Vorrichtung nach einem der Ansprüch 3 bis 5, dadurch gekennzeichnet, daß das Filter mit dem breiten Band (6) ein Band trennen kann, das zwischen 500 und 1000 Hz liegt ,und daß das Filter mit dem schmalen Band (7) ein Band trennen kann, welches zu einer Grundfrequenz von 50 Hz zentriert ist.

7. Verfahren nach Anspruch 6, dadurch gekennzeichnet, daß die Effektivwert-Gleichrichter (8, 9) identische Eigenschaften aufweisen.

## Claims

1. Method for measuring the instability of an arc (3) in an electrical furnace (1) for processing a liquid metal, according to which the quantity representative of the electric current flowing through the arc is taken into account, characterized in that:
- a signal representing the derivative (di/dt) of the strength of the current in the arc is picked up,
- the signal picked up is amplified,
- the amplified signal is passed simultaneously through two band-pass filters (6, 7), respectively with wide high-frequency band (6) and with narrow band centred on a low fundamental frequency (7),
- the signals output by the filters (6, 7) are sent to rms value extractors (8, 9),
- a signal proportional to the ratio of the rms value of the signal output by the wide-band filter (6) and of the rms value of the signal output by the narrow-band filter (7) is constructed by means of a divider module (11),
- and the proportional signal obtained is displayed on a scale (12) where it is expressed as a percentage, this percentage being indicative of the quality of the arc.

2. Method according to Claim 1, employed in a furnace where the liquid metal bath (M) is covered with a layer of foaming slag (L) at least partially passed through by the arc (3), characterized in that the said proportional signal obtained is used as an indicator of the degree of immersion of the arc (3) in the foaming slag (L), the value of the said signal tending towards a minimum when the foaming of the slag causes maximum immersion of the arc.

3. Device for implementing the method according to Claim 1 or 2, characterized in that it comprises:
- a sensor (4) of a signal representing the derivative (di/dt) of the strength of the current flowing through the arc (3),
- an amplifier (5) of the said signal,
- two band-pass filters (6, 7), connected to the amplifier (5), one (6) of which has a wide high-frequency band and the other (7) of which has a narrow band centred on a low fundamental frequency,
- two rms value extractors (8, 9) connected respectively to the aforementioned filters (6, 7),
- a divider module (11) connected to the extractors (8, 9) capable of constructing a signal proportional to the ratio of the rms value of the signal output by the wide-band filter (6) and of the rms value of the signal output by the narrow-band filter (7),
- a component (12) for displaying as a percentage the proportional signal delivered by the divider module (11),
- and an optional link to a computer.

4. Device according to Claim 3, characterized in that the sensor (4) is of the inductive type, for example a Robowski toroid.

5. Device according to one of Claims 3 or 4, characterized in that the amplifier (5) is an isolation amplifier, for example a galvanic separation amplifier.

6. Device according to one of Claims 3 to 5, characterized in that the wide-band filter (6) can isolate a band of between 500 and 1000 Hz, and the narrow-band filter (7) can isolate a band centred on a fundamental frequency of 50 Hz.

7. Device according to Claim 6, characterized in that the rms value extractors (8, 9) have identical characteristics.
